# EUROPEAN PATENT APPLICATION

(11) **EP 4 468 602 A1**
(43) Date of publication of application: **27.11.2024**
(21) Application number: 23802133.1
(22) Date of filing: 27.06.2023
(51) Int. Cl.: H03H 9/02

(54) **BULK ACOUSTIC WAVE RESONATOR, ASSEMBLY COMPRISING SAME, MANUFACTURING METHOD FOR BULK ACOUSTIC WAVE RESONATOR, ELECTRONIC DEVICE, AND FILTER**

(30) Priority: 14.04.2023 CN 202310418733
(71) Applicant: JWL (Zhejiang) Semiconductor Co., Ltd., Huzhou, Zhejiang 313000 (CN)
(72) Inventor: LI, Linping, Huzhou, Zhejiang 313000 (CN)
(74) Representative: Kolster Oy Ab
(86) International application number: PCT/CN2023/102710
(87) International publication number: WO 2024/212356

(57) **Abstract**

A bulk acoustic resonator includes a substrate, a first electrode, a second electrode, an acoustic reflection structure between the first electrode and the substrate, and a piezoelectric layer between the second electrode and the first electrode. In a direction perpendicular to the substrate, the acoustic reflection structure, the first electrode, the piezoelectric layer and the second electrode overlap to form an active region. In a direction parallel to the substrate, the active region includes first and second sides arranged oppositely, each connected to a first free end and a second free end at two ends. The active region is H in length between the first free end and the second free end, and a shortest distance from a point A on the first side to the second side is D, where H/D>3.

## Description

This application claims the priority to Chinese Patent Application No. 202310418733.6, titled "BULK ACOUSTIC RESONATOR, RESONATOR ASSEMBLY, METHOD FOR FABRICATING BULK ACOUSTIC RESONATOR, ELECTRONIC DEVICE, AND FILTER", filed on April 14, 2023 with the China National Intellectual Property Administration, which is incorporated herein by reference in its entirety.

### FIELD

The present disclosure relates to technical field of semiconductors, and in particular to a bulk acoustic resonator, a resonator assembly, a method for fabricating the bulk acoustic resonator, an electronic device and a filter.

### BACKGROUND

Film bulk acoustic resonators (Fbar) have advantages such as small size (in micron-level), high resonance frequency (GHz), high quality factor (above 2000), large power capacity, and small roll-off fact, and thus play a crucial role in the field of wireless communication. A center region of the existing resonator is far away from a substrate at an edge of the resonator, and heat is accumulated in the center region, resulting in a temperature drift in the resonator, consequently accelerating the aging and even resulting in malfunction, and reducing the reliability of the resonator.

The heat commonly dissipates by improving thermal conductivity of an electrode or passivation layer, or to improving a heat transfer coefficient of the substrate. However, the heat dissipates indirectly with such solution, resulting in poor performance in heat dissipation.

### SUMMARY

In view of this, a bulk acoustic resonator is provided according to a first aspect of the present disclosure. The bulk acoustic resonator includes: a substrate, a first electrode and a second electrode. An acoustic reflection structure is arranged between the first electrode and the substrate. A piezoelectric layer is arranged between the second electrode and the first electrode. In a direction perpendicular to the substrate, an overlapping region of the acoustic reflection structure, the first electrode, the piezoelectric layer and the second electrode is an active region. In a direction parallel to the substrate, the active region includes a first side and a second side that are arranged oppositely, the first side is connected to a first free end and a second free end at two ends of the first side, and the second side is connected to the first free end and the second free end at two ends of the second side, to form the active region that is enclosed. The active region is H in length between the first free end and the second free end, a shortest distance from a point A on the first side to the second side is D, where H/D>3.

In an embodiment, shortest distances from multiple points A to the second side are multiple distances D, the multiple distances D includes a maximum and a minimum, and a ratio of the maximum to the minimum is 1.5:1.

In an embodiment, the acoustic reflection structure ranges from 0.1µm to 0.5µm in height.

In an embodiment, in the bulk acoustic resonator, a projection of at least one of the first electrode, the piezoelectric layer, the second electrode, and the acoustic reflection structure on the substrate coincides with a projection of the active region on the substrate.

In an embodiment, in the bulk acoustic resonator, the active region between the first free end and the second free end includes at least a first region, a second region, and a connection part, the first region is connected to the second region through the connection part, and the connection part has a bending angle greater than 90° and less than or equal to 180° or the connection part is an arc-shaped connection part.

In an embodiment, in the bulk acoustic resonator, a projection of the active region on the substrate is U-shaped, S-shaped, W-shaped, spiral or serpentine-shaped.

In an embodiment, in the bulk acoustic resonator, a first inactive region and a second inactive region are arranged outside the active region. A gap is defined between the piezoelectric layer and the second electrode in the direction perpendicular to the substrate, as the first inactive region; and/or a gap is defined between the piezoelectric layer and the first electrode in the direction perpendicular to the substrate, as the first inactive region.

In an embodiment, in the bulk acoustic resonator, at least one of an upper surface of the first electrode and an upper surface of the piezoelectric layer is provided with a first recessed part, and a first gap is defined between the first recessed part and the second electrode.

In an embodiment, in the bulk acoustic resonator, the first electrode is recessed downwards or the first electrode and the piezoelectric layer are recessed downwards, to form a second recessed part, and a second gap is defined between the second recessed part and the second electrode.

A resonator assembly is provided according to a second aspect of the present disclosure. The resonator assembly includes at least the bulk acoustic resonator described above. One bulk acoustic resonator is electrically connected to another bulk acoustic resonator and/or the bulk acoustic resonator is electrically connected to at least one electrical structure.

In an embodiment, the bulk acoustic resonator is at least partially surrounded by an active region of the other bulk acoustic resonator.

In an embodiment, in the resonator assembly, bulk acoustic resonators at least partially share the active region.

A filter is provided according to a third aspect of the present disclosure. The filter includes the bulk acoustic resonator described above.

An electronic device is provided according to a fourth aspect of the present disclosure. The electronic device includes the bulk acoustic resonator described above.

A method for fabricating a bulk acoustic resonator is provided according to a fifth aspect of the present disclosure. The method includes: providing a substrate; forming an acoustic reflection structure on the substrate; forming a first electrode on a side of the acoustic reflection structure away from the substrate; forming a piezoelectric layer on a side of the first electrode away from the substrate; forming a second electrode on a side of the piezoelectric layer away from the first electrode. In a direction perpendicular to the substrate, an overlapping region of the acoustic reflection structure, the first electrode, the piezoelectric layer and the second electrode is an active region. In a direction parallel to the substrate, the active region includes a first side and a second side that are arranged oppositely. The first side is connected to a first free end and a second free end at two ends of the first side and the second side is connected to the first free end and the second free end at two ends of the second side to form the enclosed active region. The active region is H in length between the first free end and the second free end, and a shortest distance from a point A on the first side to the second side is D, where H/D>3.

Compared with the conventional technology, the present disclosure has the following beneficial effects.

The bulk acoustic resonator has a strip-shaped active region. The strip-shaped active region includes a first side and a second side that are arranged oppositely. The first side is connected to a first free end and a second free end at two ends of the first side, and the second side is connected to the first free end and the second free end at two ends of the second side. The strip-shaped active region can improve the performance of the resonator in heat dissipation. Therefore, the resonator basically remains at a constant temperature during operation. The active region is H in length between the first free end and the second free end. The shortest distance from a point A on a first side to a second side is a distance D. The length H is modified based on a resonance frequency of the resonator and a power tolerance required by the resonator, so that the length H and the distance D meet a relationship of H/D>3. The heat dissipation rate of the resonator is positively correlated with the resonance frequency, and is positively correlated with the power tolerance. Therefore, a value of H/D is further set based on the resonance frequency and the power tolerance, for a high heat dissipation rate even under high frequency and high power tolerance. Compared with the conventional sandwich structure, the force that the resonator can withstand increases, thus greatly improving the reliability of the film layers. The resonator can still operate normally for a long time even under conditions of large external vibration amplitude and vibration frequency, greatly improving the mechanical stability of the resonator and prolongating an operating lifetime of the resonator.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.

The structure, scale, and size shown in the drawings of this specification are only used for cooperation with the contents disclosed in the specification for those skilled in the art to understand and read, instead of limiting the conditions under which the present disclosure can be implemented, and thus have no technically substantive significance. Any structural modifications, changes in scale, or adjustments in size without affecting effectiveness and purpose of the present disclosure should fall within the scope of the technical contents disclosed in the present disclosure.
Figure 1 is a top view of an air-gap type bulk acoustic resonator;
Figure 2 is a cross-sectional view of the bulk acoustic resonator illustrated in Figure 1 along a BB' direction;
Figure 3 is a top view of a bulk acoustic resonator according to an embodiment of the present disclosure;
Figure 4 is a cross-sectional view of the bulk acoustic resonator illustrated in Figure 3 along an MM' direction;
Figure 5 is a top view of a cavity of the bulk acoustic resonator illustrated in Figure 3;
Figure 6 is a diagram illustrating thermodynamic simulation of a conventional resonator in a sandwich structure;
Figure 7 is a diagram illustrating thermodynamic simulation of the bulk acoustic resonator according to another embodiment of the present disclosure;
Figure 8 is a diagram illustrating thermodynamic simulation of another conventional resonator in a sandwich structure;
Figure 9 is a diagram illustrating thermodynamic simulation of the bulk acoustic resonator according to another embodiment of the present disclosure;
Figure 10 is a cross-sectional view of the bulk acoustic resonator according to another embodiment of the present disclosure;
Figure 11 is a cross-sectional view of the bulk acoustic resonator according to another embodiment of the present disclosure;
Figure 12 is a top view of the bulk acoustic resonator according to another embodiment of the present disclosure;
Figure 13 is a cross-sectional view of the bulk acoustic resonator illustrated in Figure 12 along an NN' direction;
Figure 14 is a top view of the bulk acoustic resonator according to another embodiment of the present disclosure;
Figure 15 is a cross-sectional view of the bulk acoustic resonator illustrated in Figure 14 along an FF' direction;
Figure 16 is a top view of a resonator assembly according to another embodiment of the present disclosure;
Figure 17 is a top view of the resonator assembly according to another embodiment of the present disclosure;
Figure 18 is a top view of the resonator assembly according to another embodiment of the present disclosure;
Figure 19 is a top view of the resonator assembly according to another embodiment of the present disclosure;
Figure 20 is a top view of the resonator assembly according to another embodiment of the present disclosure;
Figure 21 is a top view of the resonator assembly according to another embodiment of the present disclosure; and
Figure 22 is a top view of the resonator assembly according to another embodiment of the present disclosure.

### DETAILED DESCRIPTION

The embodiments of the present disclosure are described clearly and completely hereinafter with reference to the drawings in the embodiments of the present disclosure. Apparently, the described embodiments are some rather than all of the embodiments of the present disclosure. All of other embodiments obtained by those skilled in the art based on the embodiments in the present disclosure without any creative work fall within the protection scope of the present disclosure.

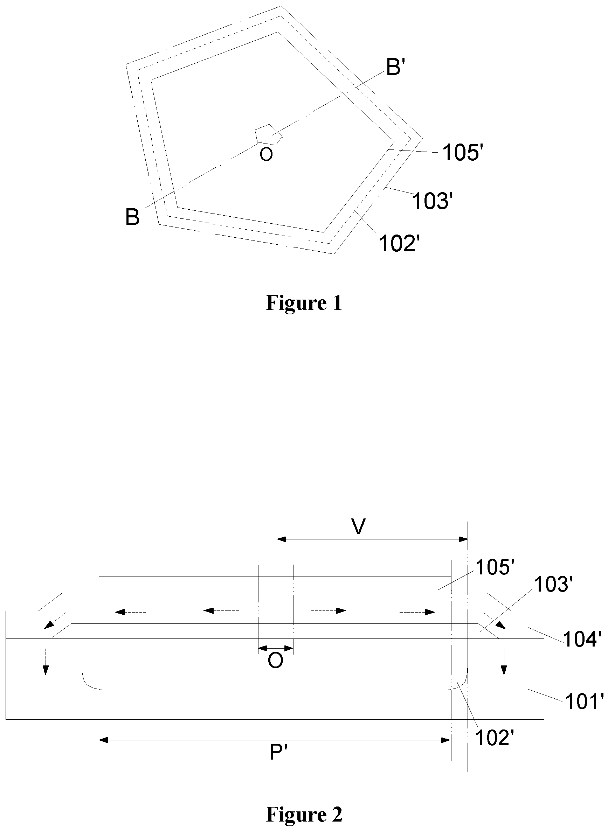

Figure 1 is a top view of an air-gap type bulk acoustic resonator, and Figure 2 is a cross-sectional view of the bulk acoustic resonator illustrated in Figure 1 along a BB' direction. The bulk acoustic resonator includes a substrate 101', an acoustic reflection structure 102', a first electrode 103', a second electrode 105', and a piezoelectric layer 104' arranged between the first electrode 103' and the second electrode 105'. An overlapping region of the acoustic reflection structure 102', the first electrode 103', the piezoelectric layer 104' and the second electrode 105' is an active region P'. The first electrode 103' and the second electrode 105' each are also known as an excitation electrode, for the piezoelectric layer 104' to generate a mechanical oscillation. The acoustic reflection structure 102' prevents an acoustic wave from being transmitted to the outside of the resonator, thereby avoiding energy loss.

In an ideal state, the resonator performs lossless conversion between mechanical energy and electrical energy. In practice, the electrical energy in the resonator and bulk sound waves are partially converted into thermal energy, which is inevitable. Further, the resonator of a higher power heats more significantly. Dashed arrows illustrated in Figure 2 represent heat transfer paths. As air is a poor conductor of heat, heat generated by the resonator mainly transfers to a part of the substrate 101' near the resonator through functional layers, that is, the electrodes and the piezoelectric layers 104', and thence to the entire substrate 101' for dissipation. Since a center region O of the resonator is far away from the substrate 101' at an edge of the resonator, the heat is inevitably accumulated in the center region O, resulting in a temperature drift in the resonator. This accelerates aging results in malfunction, and reduces the reliability of the resonator.

The heat commonly dissipates by improving thermal conductivity of the electrode or passivation layer, or to improving a heat transfer coefficient of the substrate 101'. However, the heat dissipates indirectly with such solution, resulting in poor performance in heat dissipation. Moreover, the electrode is made of material with high acoustic impedance, preferably molybdenum (Mo), tungsten, ruthenium (Ru), or iridium (Ir). The piezoelectric layer 104' is preferably made of aluminum nitride (AlN) or AlN doped with scandium (Sc), i.e., AlScN. After years of research in the industry, the foregoing materials are the most suitable for mass production of the Fbar. Therefore, it is not feasible to change the material of the piezoelectric layer 104' or the material of the electrodes. In order to improve the performance of the resonator in direct heat dissipation, a distance V from the center region O of the resonator to the substrate 101' in a direction parallel to the substrate 101' is reduced (which is applicable to both an aboveground cavity and an underground cavity, the aboveground cavity is located on an upper surface of the substrate 101', and the underground cavity is embedded inside the substrate 101'), thereby providing a shortest heat dissipation path and achieving most excellent performance in heat dissipation. However, the reduction in the distance V may directly result in a decrease in an area of the active region of the resonator. As a result, other performances of the resonator fail to meet design requirements. Therefore, how to reduce the distance V from the center region O to the substrate 101' in the direction parallel to the substrate 101' to improve the heat dissipation while guaranteeing other performances of the resonator is a core technical problem.

In view of the above problem, a bulk acoustic resonator, a resonator assembly, a method for fabricating the bulk acoustic resonator, an electronic device and a filter are provided according to the present disclosure. The bulk acoustic resonator has a strip-shaped active region, improving the performance of the resonator in heat dissipation. Therefore, the resonator basically remains at a constant temperature during operation. The active region is H in length between a first free end and a second free end. The shortest distance from a point A on a first side to a second side is a distance D. The length H is modified based on a resonance frequency of the resonator and a power tolerance required by the resonator, so that the length H and the distance D meet a relationship of H/D>3. Therefore, the resonator can perform excellently in heat dissipation, and therefore stably operate even under high frequency and high power tolerance.

In order to make the above objects, features, and advantages of the present disclosure more understandable, the present disclosure is further described in detail below in conjunction with the drawings and specific embodiments.

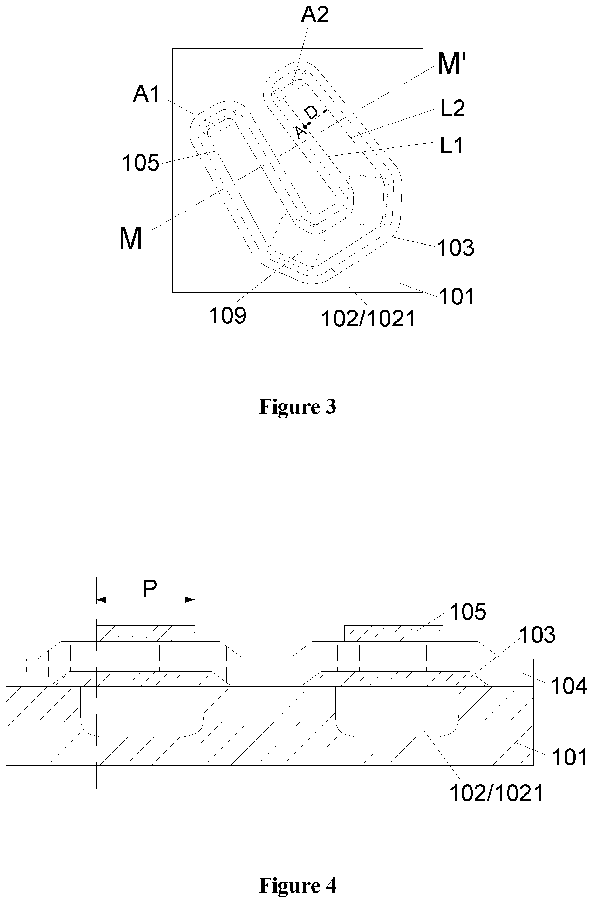

Figure 3 is a top view of the bulk acoustic resonator according to an embodiment of the present disclosure; and Figure 4 is a cross-sectional view of the bulk acoustic resonator illustrated in Figure 3 along an MM' direction. The bulk acoustic resonator includes a substrate 101, a first electrode 103, and a second electrode 105. An acoustic reflection structure 102 is arranged between the first electrode 103 and the substrate 101. A piezoelectric layer 104 is arranged between the second electrode 105 and the first electrode 103. In a direction perpendicular to the substrate 101, an overlapping region of the acoustic reflection structure 102, the first electrode 103, the piezoelectric layer 104 and the second electrode 105 is an active region P. In a direction parallel to the substrate 101, the active region P includes a first side L1 and a second side L2 that are arranged opposite to each other. The first side L1 is connected to a first free end A1 and a second free end A2 at two ends of the first side L1, and the second side L2 is connected to the first free end A1 and the second free end A2 at two ends of the second side L2, to form the enclosed active region P. The active region P is H in length between the first free end A1 and the second free end A2. The shortest distance from a point A on the first side L1 to the second side L2 is D, where H/D>3.

As shown in Figures 3 and 4, the acoustic reflection structure 102 includes a cavity 1021 or a Bragg reflection layer. The embodiments are described with an example that the acoustic reflection structure 102 is the cavity 1021. The active region P in the embodiments is U-shaped, that is, the U-shaped active region is formed by bending the active region P once. In the embodiments, the active region P can effectively improve the performance of the resonator in heat dissipation due to its shape and size, so that the resonator can basically remain at a constant temperature during operation. The length H between the first free end A1 and the second free end A2 is modified depending on the resonance frequency of the resonator and the power tolerance required by the resonator, so that the length H and the shortest distance D from the point A on the first side L1 to the second side L2 meet a relationship of H/D>3. Therefore, the resonator can perform excellently in heat dissipation and therefore stably operate even under the condition of high frequency and high power tolerance. The distance from the center region of the resonator to the substrate is greatly reduced. Therefore, compared with the conventional sandwich structure, in the resonator according to the embodiment, a torque in the center region is increased, deformation of the functional layers is greatly reduced under the same force, which indicates that a force that the resonator can withstand increases, thus greatly improving the reliability of the film layers, and effectively improving the mechanical stability of the resonator. The active region of the resonator is bent, so that the resonator is minimized in size while guaranteeing excellent performance in heat dissipation, thereby reasonably utilizing the space of the resonator. In some embodiments, the first side L1 is in the same shape as the second side L2 or a different shape than the second side L2, including straight-line, curve, or polyline.

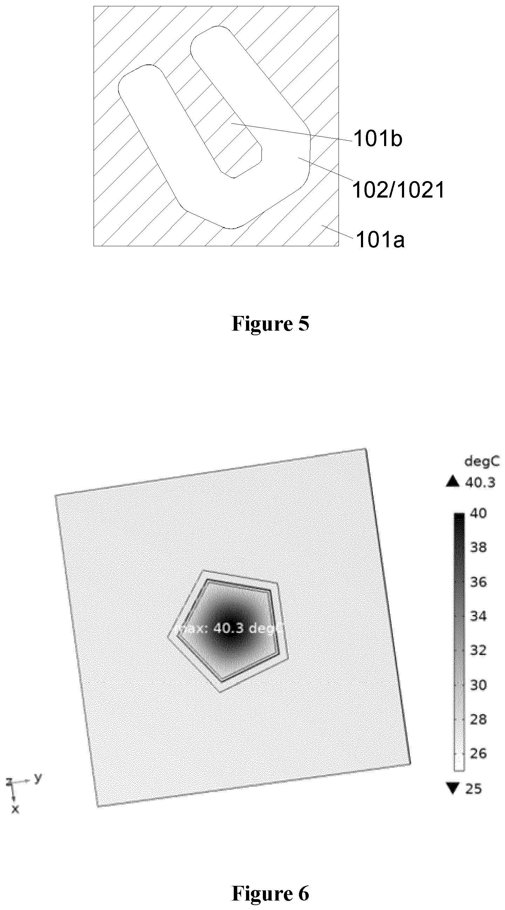

Reference is made to Figures 3 and 5. Figure 5 is a top view of a cavity of the bulk acoustic resonator illustrated in Figure 3. In the embodiment, the resonator has the strip-shaped active region P, and a projection of at least one of the first electrode 103, the piezoelectric layer 104, the second electrode 105, and the acoustic reflection structure 102 on the substrate 101 coincides with a projection of the active region P on the substrate 101.

As shown in Figures 3 and 5, the embodiment is described with an example that the acoustic reflection structure 102 is the underground cavity 1021. Preferably, the piezoelectric layer 104 is film-shaped. The acoustic reflection structure 102, the second electrode 105, and first electrode 103 are U-shaped, and correspond to each other in the direction perpendicular to the substrate 101. The U-shaped acoustic reflection structure 102 is larger than the U-shaped second electrode 105 in size. That is, the U-shaped acoustic reflection structure 102 is formed by proportionally enlarging the U-shaped active region P. The substrate 101 includes a substrate 101a and a substrate 101b. The substrate 101a and the substrate 101b support the resonator. The heat generated by the resonator dissipates through two paths of the substrate 101a and the substrate 101b. Compared with the conventional cavity structure, the substrate 101b increases the heat transfer path and further improves the performance of the resonator in heat dissipation. The first electrode 103 and a medium around the first electrode 103 have a large contact area, that is, the first electrode 103 and the substrate 101b have the large contact area. Consequently, dielectric loss of the radio frequency signal is high, or a requirement for the substrate with high impedance is increased, resulting in an increase in the cost. In such case, the first electrode 103 above the substrate 101b is etched. That is, in the embodiment, the first electrode 103 is preferably U-shaped, to reduce the contact area between the first electrode 103 and the substrate 101, thereby reducing the dielectric loss and increasing a Q value of the resonator.

As shown in Figure 3, in the resonator according to the above embodiments, the active region P between the first free end A1 and the second free end A2 includes at least a first region, a second region, and a connection part 109. The first region is connected to the second region through the connection part 109. The connection part 109 has a bending angle that is greater than 90° and less than or equal to 180°or is an arc-shaped connection part.

As shown in Figure 3, in the embodiment, the active region P of the resonator includes two first regions, one second region, and two connection parts 109. The two first regions are connected to the second region through the respective connection parts 109 to form the U-shaped active region P. The connection part 109 has the bending angle that is greater than 90° and less than or equal to 180° or is the arc-shaped connection part. In other words, the connection part 109 is formed by manufacturing a corner of the U-shaped active region P of the resonator as an obtuse angle or arc-shaped, to increase a reflection path of a transverse wave, and reduce an impact of the superposition of the transverse wave on a main vibration mode of the resonator, thereby minimizing the parasitic effect. The corners of the cavity are obtuse angles or arc-shaped, which can reduce an impact of stress on the resonator generated when the sacrificial layer is released.

The heat dissipation rate of the resonator is positively correlated with the resonance frequency, and is positively correlated with the power tolerance. Therefore, a value of H/D is further set based on the resonance frequency and the power tolerance, for a high heat dissipation rate even under high frequency and high power tolerance. For low to middle resonators, the strip-shaped active region can improve the heat dissipation rate. Especially for high-frequency resonators, the heat dissipation effect is more significant.

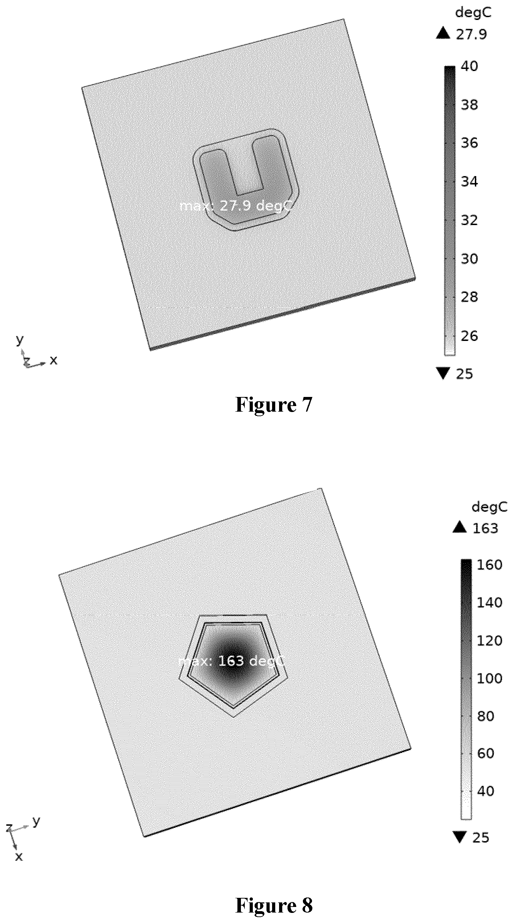

Figure 6 is a diagram illustrating thermodynamic simulation of a conventional resonator in a sandwich structure. Figure 7 is a diagram illustrating thermodynamic simulation of the bulk acoustic resonator according to another embodiment of the present disclosure. The conventional resonator in the sandwich structure shown in Figure 6 and the resonator shown in Figure 7 have active regions in equal size, and the equal resonance frequency (low to middle frequency of 2.5GHz). From the heat distribution on the conventional resonator in the sandwich structure in Figure 6, it can be seen that the heat is unevenly distributed for the conventional resonator in the sandwich structure, a location closer to the center region of the resonator has a higher temperature, the heat is accumulated in the center region with the highest temperature of 40.3°C. Compared with the conventional sandwich structure, the heat is evenly distributed for the resonator shown in Figure 7 with the highest temperature of only 27.9°C, which is 12.4°C less than 40.3°C. Therefore, the heat dissipation rate of the resonator according to the embodiment is higher than the heat dissipation rate of the conventional resonator in the sandwich structure.

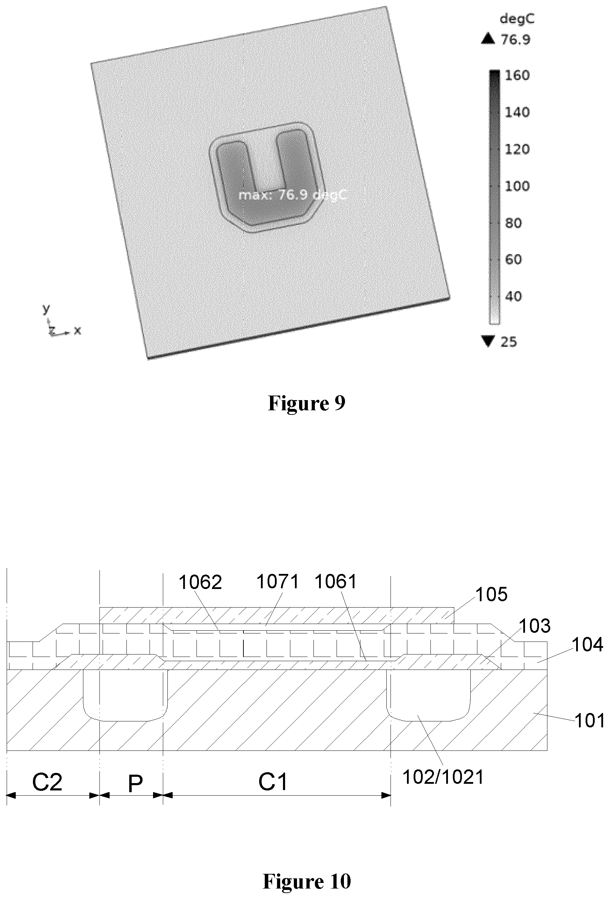

Figure 8 is a diagram illustrating thermodynamic simulation of another conventional resonator in a sandwich structure. Figure 9 is a diagram illustrating thermodynamic simulation of a bulk acoustic resonator according to another embodiment of the present disclosure. The conventional resonator in the sandwich structure shown in Figure 8 and the resonator shown in Figure 9 have active regions in equal size, and the equal resonance frequency (high frequency of 6GHz). In a case that the resonator operates at the high frequency, the functional layers have low heat dissipation rate due to the small thickness, and a change in temperature is more significant. The highest temperature at a central point of the conventional resonator in the sandwich structure shown in Figure 8 reaches 163°C. The highest temperature of the resonator shown in Figure 9 is only 76.9°C, and the heat is evenly distributed even at the high frequency and there is almost no heat accumulation. The temperature decreases from 163°C to 76.9°C, with a difference of 86.1°C.

The resonator with the strip-shaped active region performs excellently in heat dissipation, so that the resonator can operate for a long time at room temperature or slightly high temperature, thereby prolongating an operating lifetime of the resonator. The improvement in the heat dissipation rate is more significant especially for the high-frequency resonators.

In a case that the power tolerance of the resonator is constant, the resonance frequency is positively correlated with the heat dissipation rate, that is, a high resonance frequency indicates that a high heat dissipation rate required by the resonator, and a large value of H/D. Theoretically, a common filter requires a minimum power tolerance of 26dBm, i.e., 500mW, which can meet requirements for receiving, transmitting, and carrier aggregation of all signals at 4GHz to 5GHz. However, at a high frequency, e.g., 5GHz, the heating of the resonator increases exponentially. The simple optimization fails to meet the long-term reliability and performance stability of the product, and therefore further optimization is necessary. For example, for the resonance frequency of 5GHz, the distance D is set to range from 25µm to 35µm, and the length H is set to range from 90µm to 100µm.

In a case that the resonance frequency is constant, the power tolerance is positively correlated with the heat dissipation rate, that is, a high power tolerance indicates a high heat dissipation rate required by the resonator, and a large value of H/D. The structure of the resonator is modified for the filter requiring the high power tolerance, for example, 33dBm, 37dBm, and 40dBm, i.e. 1W, 5W, and 10W. For example, the value of H/D is set to range from 5 to 8, and the heat dissipation rate is achieved by increasing the value of H/D. In a case that the resonance frequency is 5GHz and the power tolerance is 500mW, the value of H/D is set to 3 while the area of the active region P is constant. In a case that the resonance frequency is 5GHz and the power tolerance is 1W, the value of H/D is set to 6 while the area of the active region P is constant. In summary, the resonator can be optimized based on the performance, the frequency band, and the power requirements, which is applicable to high power tolerance, e.g., 43dBm, i.e., 20W. The power tolerance may be a power tolerance demand of the filter or the resonator, and parameters of the resonator depend on actual requirements.

In the resonator according to the above embodiments, the shortest distances from multiple points A to the second side L2 are multiple distances D, the multiple distances D includes a maximum and a minimum, and a ratio of the maximum to the minimum is 1.5:1.

In the resonator according to the above embodiments, the active region P includes the first side L1 and the second side L2 that are arranged oppositely. The shortest distance from a point A on the first side L1 to the second side L2 is D. There are multiple points A on the first side L1. Correspondingly, the shortest distances from the multiple points A to the second side L2 are multiple distances D, and the ratio of the maximum to the minimum is 1.5:1. Within the active region P, a half of a sum of a maximum distance from the first free end A1 to the second free end A2 and a minimum distance from the first free end A1 to the second free end A2 is H, where H/D>3. The length H depends on shapes of the first free end A1 and the second free end A2. The first free end A1 and the second free end A2 each may be in, but are not limited to, a straight-line shape, a broken-line shape or an arc shape. In a case that the first free end A1 and the second free end A2 are in the straight-line shape, the length H is calculated from ends of the free ends, and is a half of a sum of a length of the first side L1 and a length of the second side L2. In a case that the first free end A1 and the second free end A2 are in the polyline shape or the arc shape, the length of the first free end A1 and the length of the second free end A2 are ignored since the first free end A1 and the second free end A2 are extremely short compared with the length of the active region P. For convenience of calculation, the length of the first free end A1 and the length of the second free end A2 are ignored. Therefore, the length H may be calculated as the half of the sum of the length of the first side L1 and the length of the second side L2. In the premise that the area of the active region P is constant, as the length H increases, a value of D/2 decreases, effectively reducing a distance from a heat concentration region to the substrate 101, thereby improving the heat dissipation rate. Furthermore, K=H/D is defined as a heat dissipation index of the resonator. In the premise that the substrate, the electrodes, the piezoelectric layer 104 are constant in material and thickness and the active region is constant in area, a large K indicates a low operating temperature of the resonator. Preferably, K is greater than 3.

In the resonator according to the above embodiments, the acoustic reflection structure 102 ranges from 0.1µm to 0.5µm in height.

In a case that the acoustic reflection structure 102 is the cavity 1021, the cavity 1021 normally ranges from 0.5µm to 2µm in height, which can prevent the first electrode 103 and other functional layers above the substrate 101 from adhering to the substrate 101 when the resonator resonates. In the embodiments, the active region A1 is such formed that the distance D is as small as possible while the resonator has the desired size. Compared with the conventional sandwich structure, the deformation of the functional layers is greatly reduced under the same force. That is, a force that the resonator can withstand increases, thus greatly improving the reliability of the film layers. In such case, the height of the cavity 1021 may be reduced to range from 0.1µm to 0.5µm, and the heat dissipation path is further shortened, thereby further improving the heat dissipation rate of the resonator.

As the height of the cavity 1021 embedded inside the substrate 101 is increased, for example, greater than 0.5µm, the height of the substrate 101 is also increased, and the heat transfer path of the resonator from the upper surface of the substrate 101 to the lower surface of the substrate 101 is lengthened. As a result, heat is accumulated in a longitudinal direction of the substrate 101, which is not conducive to heat dissipation. In a case that the height of the cavity 1021 is less than 0.1µm, the functional layers of the resonator adhere to the substrate 101. In the embodiments, the height of the cavity 1021 is set to range from 0.1µm to 0.5µm. Compared with the conventional cavity 1021, as the height of the cavity 1021 is reduced, the height of the substrate 101 is reduced, and the heat transfer path in the longitudinal direction of the substrate 101 is shortened, so that the heat transfers along a bottom of the cavity 1021, that is, along a transverse direction of the substrate 101. Therefore, with the reduction of the height of the cavity 1021, the heat transfers path from the surface of the substrate 101 instead of both ends of the substrate 101, thereby greatly improving the heat dissipation rate. Moreover, as the height of the cavity 1021 is reduced, deposition cost of the sacrificial layer is reduced, and the release is sped up.

In the above embodiments, in a case that the acoustic reflection structure 102 is the Bragg reflection layer which is in directly contact with the functional layers, a thin Bragg reflection layer leads to low thermal resistance between the functional layers and the lower surface of the substrate. Therefore, as the height of the acoustic reflection structure 102 is reduced to range from 0.1µm to 0.5µm, the heat dissipation path can be shortened, thereby improving the heat dissipation rate and reducing the cost of fabricating the Bragg reflector layer.

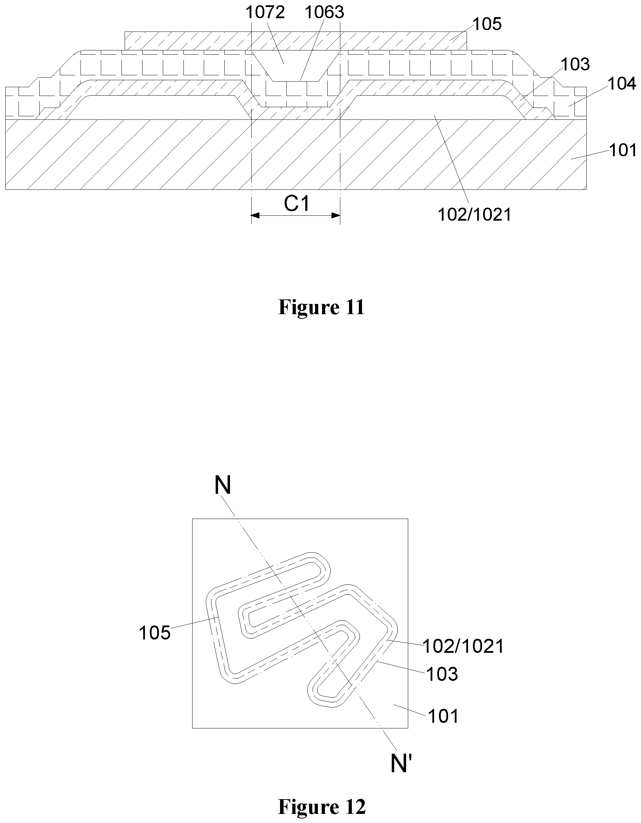

Figure 10 is a cross-sectional view of a bulk acoustic resonator according to another embodiment of the present disclosure, and Figure 11 is a cross-sectional view of a bulk acoustic resonator according to another embodiment of the present disclosure. A first inactive region C1 and a second inactive region C2 are arranged outside the active region P. In the direction perpendicular to the substrate 101, a gap is defined between the piezoelectric layer 104 and the second electrode 105 and/or a gap is defined between the piezoelectric layer 104 and the first electrode 103, to form the first inactive region C1.

As shown in Figures 10 and 11, in the direction perpendicular to the substrate 101, a gap is defined between the piezoelectric layer 104 and the second electrode 105, and/or a gap is defined between the piezoelectric layer 104 and the first electrode 103, so that the film layers corresponding to the gap are isolated from each other. That is, the piezoelectric layer 104 corresponding to the gap is in no contact with the second electrode 105 or the first electrode 103 at least in the direction perpendicular to the substrate 101, thereby avoiding the generation of the additional parasitic oscillation. In addition, the gap provided in the resonator includes but is not limited to: one gap or two gaps between two of the first electrode 103, the piezoelectric layer 104, and the second electrode 105 above the substrate 101 inside the acoustic reflection structure 102, to form the first inactive region C1 in the region. In the embodiment, the resonator further includes a second inactive region C2. The second inactive region C2 is a region of the resonator other than the first inactive region C1 and the active region P.

As shown in Figure 10, in another embodiment of the present disclosure, at least one of an upper surface of the first electrode 103 and an upper surface of the piezoelectric layer 104 is provided with a first recessed part 1061. A first gap 1071 is provided between the first recessed part 1061 and the second electrode 105.

As shown in Figure 10, the acoustic reflection structure 102 is U-shaped and is embedded inside the substrate 101. In the direction perpendicular to the substrate 101, the upper surface of the first electrode 103 is provided with the first recessed part 1061. As the first recessed part 1061 deforms, the piezoelectric layer 104 deposited on the first recessed part 1061 also deforms to form a third recessed part 1062. The second electrode 105 is deposited on the piezoelectric layer 104 across the third recessed part 1062, and the first gap 1071 is formed between the third recessed part 1062 and the second electrode 105. In another embodiment, the upper surface of the first electrode 103 is provided with the first recessed part 1061, and the piezoelectric layer 104 extends horizontally across the first recessed part 1061, that is, the upper surface of the piezoelectric layer 104 is not recessed, so that the first gap 1071 is formed between the first recessed part 1061 and the piezoelectric layer 104. In another embodiment, the first electrode 103 is film-shaped, and the upper surface of the first electrode 103 is not recessed. Instead, the first recessed part 1061 is directly formed on the piezoelectric layer 104 through etching or the like. The second electrode 105 is deposited on the piezoelectric layer 104 across the first recessed part 1061. The first gap 1071 separates the second electrode 105 from the piezoelectric layer 104 in the direction perpendicular to the substrate 101, so that the second electrode 105 is in no contact with the piezoelectric layer 104 in the direction perpendicular to the substrate 101, thereby avoiding the generation of the additional parasitic oscillation. In other embodiments, a central region of the first electrode 103 is partially or completely etched, so that a gap is formed between the first electrode 103 and piezoelectric layer 104 extending on the first electrode 103. Alternatively, the first electrode 103 is etched to expose the surface of the substrate 101, and therefore a gap is formed between the piezoelectric layer 104 and the exposed surface of the substrate 101.

As shown in Figure 11, the first electrode 103 is recessed downwards or the first electrode 103 and the piezoelectric layer 104 are recessed downwards, to form a second recessed part 1063. A second gap 1072 is provided between the second recessed part 1063 and the second electrode 105. The second gap 1072 is arranged in the first inactive region C1.

In the resonator shown in Figure 11, both the first electrode 103 and the piezoelectric layer 104 are not etched or subjected to other processing, and the acoustic reflection structure 102 is arranged on the surface of the substrate 101 and between the first electrode 103 and the substrate 101. That is, the first electrode 103 protrudes in the active region P and is recessed downwards in the first inactive region C1 to form the second recessed part 1063. The piezoelectric layer 104 and the second electrode 105 extend on the second recessed part 1063, so that the second gap 1072 is formed between the second recessed part 1063 of the first electrode 103 and the piezoelectric layer 104. Alternatively, the first electrode 103 protrudes in the active region P and is recessed downwards in the first inactive region C1, the piezoelectric layer 104 is directly formed on the first electrode 103 and is recessed as the first electrode 103 is recessed, so that the second recessed part 1063 is formed on the piezoelectric layer 104. The second gap 1072 is formed between the second recessed part 1063 of the piezoelectric layer 104 and the second electrode 105, and the second gap 1072 is arranged in the first inactive region C1. The acoustic reflection structure 102 is the cavity 1021. In the embodiment, in the direction perpendicular to the substrate 101, the second gap 1072 separates the piezoelectric layer 104 from the second electrode 105, so that the resonator does not generate additional parasitic oscillation at a region where the second gap 1072 is located. The above gap may be filled with air or a dielectric material, as long as generation of additional parasitic oscillation can be avoided.

In the resonator according to the above embodiments, the projection of the active region P on the substrate 101 is U-shaped, S-shaped, W-shaped, spiral or serpentine-shaped.

The active region P is bent at least once to minimize the resonator in size without affecting the heat dissipation rate. In the premise that the active region P is constant in size, the resonator is strip-shaped. Specifically, the length H of the active region P is increased and a width D of the active region P is reduced to increase a circumference of the resonator, thereby improving the performance in heat dissipation.

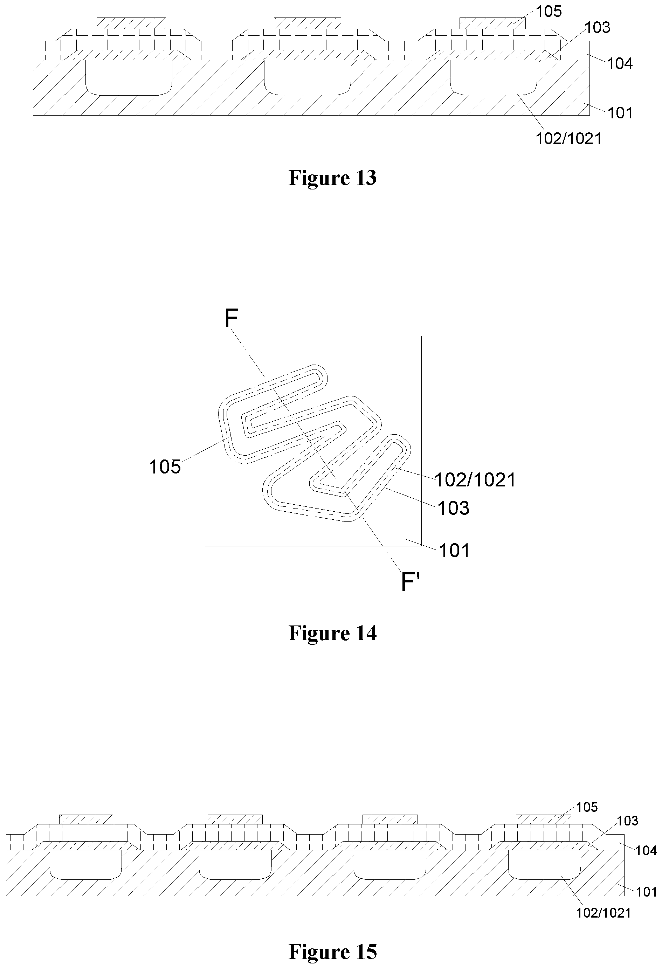

Figure 12 is a top view of the bulk acoustic resonator according to another embodiment of the present disclosure, and Figure 13 is a cross-sectional view of the bulk acoustic resonator illustrated in Figure 12 along an NN' direction. In the embodiments, the active region P is bent twice to form an S-shaped active region P. The first free end A1 and the second free end A2 of the active region P are arranged towards different directions. The acoustic reflection structure 102, the first electrode 103 and the second electrode 105 are all S-shaped, and the piezoelectric layer 104 is film-shaped. The resonator according to the embodiment is described with the example that the acoustic reflection structure 102 is the cavity 1021.

Figure 14 is a top view of a bulk acoustic resonator according to another embodiment of the present disclosure, and Figure 15 is a cross-sectional view of the bulk acoustic resonator illustrated in Figure 14 along an FF' direction. In the embodiment, the active region P is bent three times to form the W-shaped active region P. The first free end A1 and the second free end A2 of the active region P are arranged towards in the same direction. The acoustic reflection structure 102, the first electrode 103 and the second electrode 105 are all W-shaped, and the piezoelectric layer 104 is film-shaped. The resonator according to the embodiment is described with the example that the acoustic reflection structure 102 is the cavity 1021. Further, the active region P of the resonator may be bent multiple times to form a spiral active region or a serpentine-shaped active region. The serpentine-shaped active region is formed by connecting multiple S-shaped active regions.

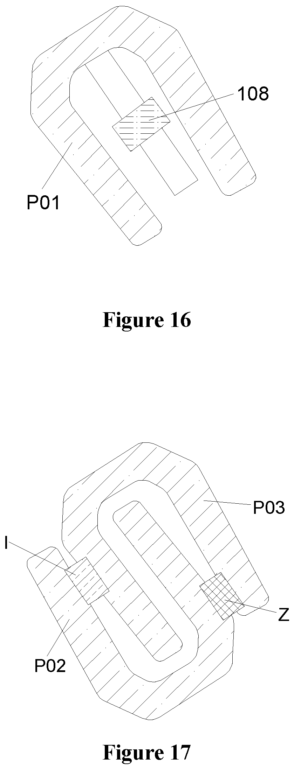

Figure 16 is a top view of the resonator assembly according to another embodiment of the present disclosure. Based on the above resonator, a resonator assembly is provided according to another embodiment of the present disclosure. The resonator assembly includes the resonator according to any one of the above embodiments. Bulk acoustic resonators in the resonator assembly are electrically connected, and/or the bulk acoustic resonator in the resonator assembly is electrically connected to at least one electrical structure 108.

As shown in Figure 16, the resonator assembly is provided according to the embodiment. The resonator assembly includes a resonator with a U-shaped active region P01 and an electrical structure 108. In the resonator assembly according to the embodiment, a center of a first inactive region C1 semi-surrounded by the U-shaped active region P01 is connected to the electrical structure 108. The electrical structure 108 may be but is not limited to a capacitor (C), an inductor (L), and an LC circuit. The second electrode 105 (or the first electrode 103) in the active region P01 is connected to the outside. The first electrode 103 (or the second electrode 105) in the first inactive region C1 is connected to one end of the capacitor (C), the inductor (L), or the LC circuit. The capacitor (C), the inductor (L), or the LC circuit is electrically connected to the outside. A space in the central region is reasonably utilized to reduce an overall size of a chip.

In some embodiments, the resonator assembly further includes at least two strip-shaped resonators that are connected to each other. The strip-shaped resonator is U-shaped, W-shaped, spiral, or serpentine-shaped.

Figure 17 is a top view of the resonator assembly according to another embodiment of the present disclosure. One bulk acoustic resonator is at least partially arranged within the active region of another bulk acoustic resonator.

As shown in Figure 17, the resonator assembly is formed by interlacing two resonators with a U-shaped active region, for example. In the embodiment, at least one of the first free end A1 and the second free end A2 of an active region P02 is semi-surrounded by an active region P03. That is, at least one of the first free end A1 and the second free end A2 of the active region P03 is located within the first inactive region C1 corresponding to the active region P02, and the two active regions are connected via a second connection end Z and a first connection end I. The active region P03 is connected in parallel with or in series to the active region P02 as needed, via the first connection end I and the second connection end Z. specifically, the second electrode 105 of the active region P03 is connected to the second electrode 105 of the active region P02, and the first electrode 103 of the active region P03 is connected to the first electrode 103 of the active region P02. Alternatively, the second electrode 105 of the active region P03 is connected to the first electrode 103 of the active region P02.

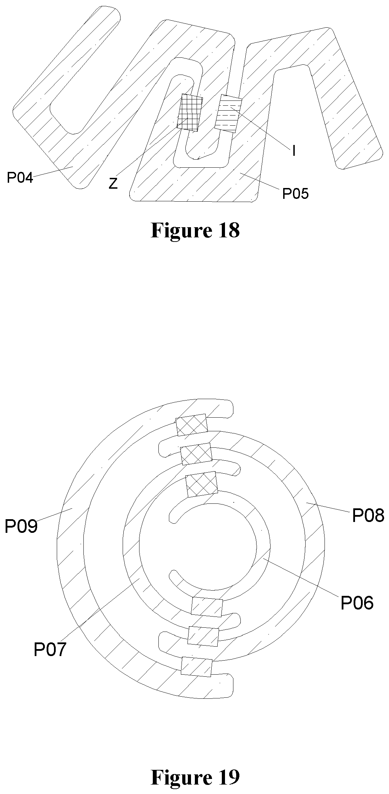

Figure 18 is a top view of the resonator assembly according to another embodiment of the present disclosure. The embodiment is described with an example that the resonator assembly is formed by interlacing two resonators with an S-shaped active region. An active region P04 is partially semi-surrounded by an active region P05. The two active regions are connected to each other through two connection ends, and reference is made to Figure 17.

Figure 19 is a top view of the resonator assembly according to another embodiment of the present disclosure. The embodiment is described with an example that the resonator assembly is formed by interlacing four resonators with a U-shaped active region. Two free ends of an active region P06 are surrounded by the active region P07, two free ends of the active region P07 are surrounded by an active region P08, and two free ends of the active region P08 are surrounded by an active region P09, thereby forming the resonator assembly by interlacing multiple resonators. The four resonators are connected through connection ends, and reference is made to Figure 17.

In the resonator assembly according to another embodiment of the present disclosure, multiple bulk acoustic resonators at least partially share the active region.

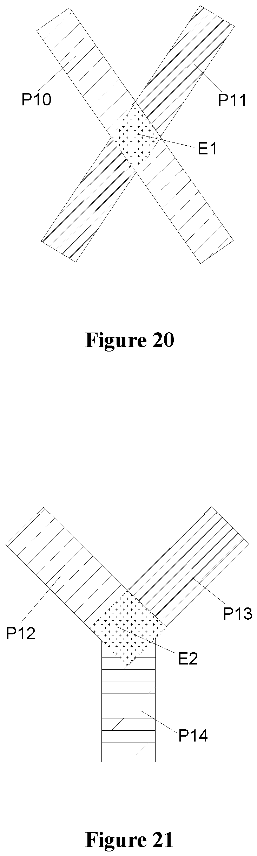

Figure 20 is a top view of a resonator assembly according to another embodiment of the present disclosure. The embodiment is described with an example that the resonator assembly includes two strip-shaped resonators. The resonator assembly includes an active region P10 and an active region P11.The resonator assembly has a first common active region E1. In other words, the active region P10 intersects with the active region P11, to form the common active region E1 at the intersection. Both the active region P10 and the active region P11 meet the relationship of H/D>3, so that the resonator assembly is decreased in size without affecting the heat dissipation rate, thereby reasonably utilizing the space.

Figure 21 is a top view of the resonator assembly according to another embodiment of the present disclosure. The embodiment is described with an example that the resonator assembly includes three strip-shaped resonators. The resonator assembly includes an active region P12, an active region P13, and an active region P14. The resonator assembly has a second common active region E2. In other words, the active region P12, the active region P13, and the active region P14 intersect, to form the second common active region E2 at the intersection, which is located at any one of free ends of the active region P12. The active region P13, and the active region P14. Both the active region P12, the active region P13, and the active region P14 meet the relationship of H/D>3.

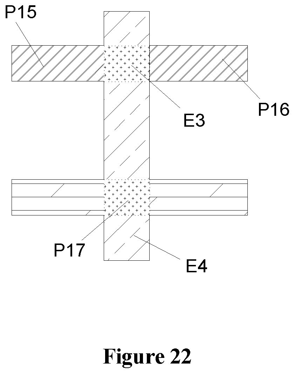

Figure 22 is a top view of a resonator assembly according to another embodiment of the present disclosure. The embodiment is described with an example that the resonator assembly includes three strip-shaped resonators. The resonator assembly includes an active region P15, an active region P16, and an active region P17. The resonator assembly has a third common active region E3 and a fourth common active region E4. In other words, the active region P15, the active region P16, and the active region P17 intersect, to form the third common active region E3 and the fourth common active region E4 at intersections. The common active region is formed in the middle of the active region of the resonator. The above description only illustrates a situation of multiple strip-shaped resonators connected, and the number of the resonators and the number of the common active regions depend on the size and the heat dissipation rate.

Based on the above embodiments, a filter is further provided according to another embodiment of the present disclosure. The filter includes the bulk acoustic resonator according to any one of the above embodiments, or includes at least one of the resonator assembly.

Based on the above embodiments, an electronic device is further provided according to another embodiment of the present disclosure. The electronic device includes the bulk acoustic resonator according to any one of the above embodiments.

Based on the above embodiments, a method for fabricating the resonator is further provided according to another embodiment of the present disclosure.

As shown in Figure 4, the method for fabricating a bulk acoustic resonator is provided according to another embodiment of the present disclosure. The method includes as follows. A substrate 101 is provided. An acoustic reflection structure 102 is formed on the substrate 101. A first electrode 103 is formed on a side of the acoustic reflection structure 102 away from the substrate 101. A piezoelectric layer 104 is formed on a side of the first electrode 103 away from the substrate 101. A second electrode 105 is formed on a side of the piezoelectric layer 104 away from the first electrode 103. In a direction perpendicular to the substrate 101, an overlapping region of the acoustic reflection structure 102, the first electrode 103, the piezoelectric layer 104, and the second electrode 105 is an active region P. In a direction parallel to the substrate 101, the active region P includes a first side L1 and a second side L2 that are arranged oppositely. The first side L1 is connected to a first free end A1 and a second free end A2 at two ends of the first side L1, and the second side L2 is connected to the first free end A1 and the second free end A2 at two ends of the second side L2, to form the closed active region P. The active region P is H in length between the first free end A1 and the second free end A2. The shortest distance from a point A on the first side L1 to the second side L2 is D, where H/D>3. The substrate 101 is preferably made of Si, sapphire, spinel or the like. The acoustic reflection structure 102 is a cavity 1021 or a Bragg reflection layer. Preferably, the first electrode 103 is made of molybdenum (Mo). In another embodiment, the first electrode 103 is made of metal or alloy such as gold (Au), tungsten (W), copper (Cu), nickel (Ni), titanium (Ti), niobium (Nb), silver (Ag), tantalum (Ta), cobalt (Co), or aluminum (Al). Preferably, the piezoelectric layer 104 is made of aluminum nitride (AlN), zinc oxide (ZnO), zinc sulfide (ZnS), lithium tantalate (LiTaO₃), cadmium sulfide (CdS), lead titanate (PbTiO₃), lead zirconate titanate (Pb (Zr, Ti) O₃), and the like. Preferably, the second electrode 105 is made of molybdenum (Mo). In another embodiment, the second electrode 105 is made of metal or alloy such as gold (Au), tungsten (W), copper (Cu), nickel (Ni), titanium (Ti), niobium (Nb), silver (Ag), tantalum (Ta), cobalt (Co), or aluminum (Al). The materials of the substrate 101, the first electrode 103, the second electrode 105, and the piezoelectric layer 104 include but are not limited to the above materials.

Based on the embodiments of the present disclosure, the bulk acoustic resonator, the resonator assembly, the method for fabricating the bulk acoustic resonator, the electronic device and the filter are provided according to the present disclosure. The bulk acoustic resonator has the strip-shaped active region P to improve the heat dissipation rate of the resonator, so that the resonator basically can remain at constant temperature during operation. The length H of the active region P between the first free end and the second free end is greater than a length between the first side L1 and the second side L2. The shortest distance from a point A on the first side L1 to the second side L2 is D. The length H is modified based on the resonance frequency of the resonator and the power tolerance required by the resonator, for the purpose of H/D>3. Therefore, the resonator can perform excellently in heat dissipation and therefore stably operate even under the condition of high frequency and high power tolerance. Moreover, the resonator has high structural strength, greatly improving the mechanical stability of the resonator.

The embodiments in this specification are described in progressive, in parallel, or in a combination of progressive and parallel, each of which emphasizes the differences from others, and the same or similar parts among the embodiments can be referred to each other. The resonator assembly, the filter, the electronic device, and the method for fabricating the bulk acoustic resonator according to the embodiments are described simply, as they correspond to the resonator disclosed in the embodiments. Reference may be made to the description of the method for relevant parts.

In the description of the present disclosure, it should be understood that the drawings and the description of the embodiments are illustrative rather than restrictive. The same reference numerals are used to identify the same structures throughout the embodiments of the specification. In addition, thicknesses of some layers, films, panels, or areas may be enlarged in the drawings for ease of understanding and description. It may be understood that, an element such as a layer, a film, an area or a substrate, when described as being "on" another element, may be directly or in directly on another element. In addition, the term "on" indicates to arrange an element on or below another element, and does not essentially indicate to arrange an element on top of another element in a direction of gravity.

The orientation or positional relationship indicated by the terms "upper", "lower", "top", "bottom", "inside", and "outside" and the like is based on the orientation or positional relationship shown in the drawings, and is merely for the convenience of describing the present disclosure or simplifying the description, instead of indicating or implying that the device or element must have a specific orientation or be constructed or operated in a specific orientation, and therefore cannot be understood as a limitation of the present disclosure. A component considered as being "connected" to another component may be directly or in directly connected to another component.

It should be further noted that the relationship terms herein such as "first", "second" and the like are merely used for distinguishing one entity or operation from another rather than necessitating or implying that any such actual relationship or order exists between entities or operations. Moreover, the terms "comprise", "include", or any other variants thereof are intended to be non-exclusive, such that the article, or device including a series of elements includes not only those elements but also elements that are not explicitly listed, or elements that are inherent in such article, or device. Unless explicitly limited, the statement "including a ..." does not exclude the case that other similar elements may exist in the article or device including the elements.

Based on the above description of the disclosed embodiments, those skilled in the art can implement or carry out the present disclosure. It is apparent that those skilled in the art may make many modifications to these embodiments. The general principle defined herein may be applied to other embodiments without departing from the spirit or scope of the present disclosure. Therefore, the present disclosure is not limited to the embodiments illustrated herein but has the widest scope that complies with the principle and novelty disclosed in the present disclosure.

## Claims

1. A bulk acoustic resonator, comprising:
a substrate;
a first electrode, wherein an acoustic reflection structure is arranged between the first electrode and the substrate;
a second electrode, wherein a piezoelectric layer is arranged between the second electrode and the first electrode, wherein
in a direction perpendicular to the substrate, an overlapping region of the acoustic reflection structure, the first electrode, the piezoelectric layer and the second electrode is an active region; and
in a direction parallel to the substrate, the active region comprises a first side and a second side that are arranged oppositely, the first side is connected to a first free end and a second free end at two ends of the first side and the second side is connected to the first free end and the second free end at two ends of the second side to form the active region that is enclosed; and the active region is H in length between the first free end and the second free end, and a shortest distance from a point A on the first side to the second side is D, wherein H/D>3.

2. The bulk acoustic resonator according to claim 1, wherein shortest distances from a plurality of points A to the second side are a plurality of distances D, the plurality of distances D comprises a maximum and a minimum, and a ratio of the maximum to the minimum is 1.5:1.

3. The bulk acoustic resonator according to claim 1, wherein the acoustic reflection structure ranges from 0.1µm to 0.5µm in height.

4. The bulk acoustic resonator according to claim 1, wherein a projection of at least one of the first electrode, the piezoelectric layer, the second electrode, and the acoustic reflection structure on the substrate coincides with a projection of the active region on the substrate.

5. The bulk acoustic resonator according to claim 1, wherein the active region between the first free end and the second free end comprises at least a first region, a second region, and a connection part, the first region is connected to the second region through the connection part, and the connection part has a bending angle greater than 90° and less than or equal to 180° or the connection part is arc-shaped.

6. The bulk acoustic resonator according to claim 1, wherein a projection of the active region on the substrate is U-shaped, S-shaped, W-shaped, spiral or serpentine-shaped.

7. The bulk acoustic resonator according to claim 1, wherein
a first inactive region and a second inactive region are arranged outside the active region; and
a gap is defined between the piezoelectric layer and the second electrode in the direction perpendicular to the substrate, as the first inactive region; and/or a gap is defined between the piezoelectric layer and the first electrode in the direction perpendicular to the substrate, as the first inactive region.

8. The bulk acoustic resonator according to claim 7, wherein at least one of an upper surface of the first electrode and an upper surface of the piezoelectric layer is provided with a first recessed part, and a first gap is defined between the first recessed part and the second electrode.

9. The bulk acoustic resonator according to claim 7, wherein the first electrode is recessed downwards or the first electrode and the piezoelectric layer are recessed downwards, to form a second recessed part, and a second gap is defined between the second recessed part and the second electrode.

10. A resonator assembly, comprising at least the bulk acoustic resonator according to any one of claims 1 to 9, wherein
bulk acoustic resonators are electrically connected; and/or
the bulk acoustic resonator is electrically connected to at least one electrical structure.

11. The resonator assembly according to claim 10, wherein the bulk acoustic resonator is at least partially surrounded by an active region of another bulk acoustic resonator.

12. The resonator assembly according to claim 10, wherein the bulk acoustic resonators at least partially share an active region.

13. A filter, comprising the bulk acoustic resonator according to any one of claims 1 to 9.

14. An electronic device, comprising the bulk acoustic resonator according to any one of claims 1 to 9.

15. A method for fabricating a bulk acoustic resonator, comprising:
providing a substrate;
forming an acoustic reflection structure on the substrate;
forming a first electrode on a side of the acoustic reflection structure away from the substrate;
forming a piezoelectric layer on a side of the first electrode away from the substrate;
forming a second electrode on a side of the piezoelectric layer away from the first electrode, wherein
in a direction perpendicular to the substrate, an overlapping region of the acoustic reflection structure, the first electrode, the piezoelectric layer and the second electrode is an active region; and
in a direction parallel to the substrate, the active region comprises a first side and a second side that are arranged oppositely, the first side is connected to a first free end and a second free end at two ends of the first side and the second side is connected to the first free end and the second free end at two ends of the second side to form the enclosed active region; and the active region is H in length between the first free end and the second free end, and a shortest distance from a point A on the first side to the second side is D, wherein H/D>3.
